(19) Europäisches Patentamt

European Patent Office

Office européen des brevets

(11) **EP 4 692 012 A1**

(12) **EUROPEAN PATENT APPLICATION**
published in accordance with Art. 153(4) EPC

(43) Date of publication:
**11.02.2026 Bulletin 2026/07**

(21) Application number: **24862028.8**

(22) Date of filing: **05.09.2024**

(51) International Patent Classification (IPC):
*C03C 17/34* (2006.01)     *G02B 1/113* (2015.01)

(52) Cooperative Patent Classification (CPC):
**C03C 17/34; G02B 1/113; G09F 9/30**

(86) International application number:
**PCT/CN2024/117081**

(87) International publication number:
**WO 2025/051188 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **08.09.2023 CN 202311163164**

(71) Applicant: **Huawei Technologies Co., Ltd.
Shenzhen, Guangdong 518129 (CN)**

(72) Inventors:
• **LI, Fengxiang
  Shenzhen, Guangdong 518129 (CN)**
• **LIN, Geng
  Shenzhen, Guangdong 518129 (CN)**
• **HUANG, Yihong
  Shenzhen, Guangdong 518129 (CN)**
• **JIANG, WenJie
  Shenzhen, Guangdong 518129 (CN)**
• **YUAN, Jiansong
  Shenzhen, Guangdong 518129 (CN)**

(74) Representative: **Huawei European IPR
Huawei Technologies Duesseldorf GmbH
Riesstraße 25
80992 München (DE)**

(54) **GLASS PANEL, DISPLAY SCREEN AND TERMINAL**

(57)    A glass panel (100) is provided, including a glass panel substrate (10) and a composite film layer (20) disposed on a surface of the glass panel substrate (10). The composite film layer (20) includes a first base layer (21), a first barrier layer (22), a diamond-like carbon film layer (23), a second barrier layer (24), a second base layer (25), and an anti-fingerprint layer (26) that are sequentially stacked. The glass panel (100) is coated with the composite film layer (20) having a specific structure on the surface of the glass panel substrate (10), so that the glass panel (100) can have high Mohs hardness, to improve a scratch resistance capability of the glass panel (100). In addition, the composite film layer (20) has strong adhesion to the surface of the substrate and is not easily detached. The composite film layer (20) can further reduce a color difference before and after coating to a specific extent, and increase transmittance. A display (200) and a terminal (300) that include the glass panel (100) are further provided.

FIG. 1

EP 4 692 012 A1

**Description**

This application claims priority to Chinese Patent Application No. 202311163164.1, filed with the China National Intellectual Property Administration on September 8, 2023 and entitled "GLASS PANEL, DISPLAY, AND TERMINAL", which is incorporated herein by reference in its entirety.

TECHNICAL FIELD

Embodiments of this application relate to the field of glass panel technologies, and in particular, to a glass panel, a display, and a terminal.

BACKGROUND

Currently, displays with glass panels have been widely used in terminal devices such as mobile phones, tablet computers, and wearable products. To improve a scratch resistance capability of a glass panel, in the industry, a protective film is usually attached to a surface of a glass panel substrate externally, or the protective film is directly coated on the surface of the glass panel substrate externally. However, externally attaching the protective film to the surface of the glass panel substrate not only increases component costs, but also reduces an optical characteristic of a screen, affecting a product appearance. An existing externally-coated protective film has the following problems: limited improvement of the scratch resistance capability of the glass panel, easy detachment of the protective film due to insufficient adhesion, a clear color difference before and after coating, a clear reduction in transmittance, and the like.

SUMMARY

In view of this, embodiments of this application provide a glass panel. The glass panel is coated with a composite film layer having a specific structure on a surface of a glass panel substrate, so that the glass panel can have high Mohs hardness, to improve a scratch resistance capability of the glass panel. In addition, the composite film layer has strong adhesion to the surface of the substrate and is not easily detached. The composite film layer can further reduce a color difference before and after coating to a specific extent, and increase transmittance.

A first aspect of embodiments of this application provides a glass panel, including a glass panel substrate and a composite film layer disposed on a surface of the glass panel substrate. The composite film layer includes a first base layer, a first barrier layer, a diamond-like carbon film layer, a second barrier layer, a second base layer, and an anti-fingerprint layer that are sequentially stacked.

Materials of the first base layer and the second base layer are independently selected from one or more of an oxide of silicon or an oxide of aluminum, and materials of the first barrier layer and the second barrier layer are independently selected from one or more of $SiN_x$, $CN_x$, $SiC_x$, or $SiN_xC_y$, where values of x and y range from 1 to 6. A thickness of the first base layer ranges from 2 nm to 30 nm, a thickness of the first barrier layer ranges from 1 nm to 20 nm, a thickness of the diamond-like carbon film layer ranges from 3 nm to 40 nm, a thickness of the second barrier layer ranges from 1 nm to 20 nm, a thickness of the second base layer ranges from 2 nm to 30 nm, a thickness of the anti-fingerprint layer is less than or equal to 20 nm, and a thickness of the composite film layer is less than 100 nm.

According to the glass panel provided in embodiments of this application, the composite film layer is coated on the surface of the glass panel substrate, so that the glass panel can have high Mohs hardness, a color difference and a transmittance difference before and after coating are reduced, and the composite film layer has strong adhesion to the surface of the substrate. At the composite film layer, the first base layer is in contact with and stacked on the glass panel substrate. The first base layer can increase adhesion of the composite film layer to the glass panel substrate, to reduce a risk of detachment of the composite film layer, and improve use reliability of the glass panel. The diamond-like carbon film layer has high hardness, and can improve a scratch resistance capability of the glass panel, to help reduce a total thickness of the composite film layer. In addition, the diamond-like carbon film layer can further reduce a color difference of the composite film layer before and after coating. Disposing of the first barrier layer and the second barrier layer helps increase overall hardness of the glass panel, and can avoid adverse effects such as oxidation of the diamond-like carbon film layer during preparation of the composite film layer and during use of the glass panel, so that the glass panel can better maintain long-term high hardness. Disposing of the anti-fingerprint layer can reduce residues of fingerprints, stains, and the like during use of the glass panel, and improve user experience. Disposing of the second base layer can increase adhesion of the anti-fingerprint layer, so that the glass panel can maintain long-term anti-smudge performance. In addition, in this application, a total thickness of the composite film layer is controlled to be less than or equal to 100 nm by appropriately controlling a thickness of each layer at the composite film layer to be a small value. Hardness, adhesion, and optical performance can be better balanced under a collaborative action of the film layers, so that stress of the composite film layer is controlled to be at a low level, to effectively avoid a surface shape change of the glass panel substrate and detachment of the composite film layer that are caused by the stress of the film layer, increase the adhesion of the composite film layer to the surface of the glass panel substrate, and prolong a service life of the composite film layer. In this way, a glass panel with excellent comprehensive performance is obtained to better meet a requirement of a terminal device.

In an implementation of this application, the composite film layer further includes a first optical film layer disposed between the first base layer and the first barrier layer, and/or a second optical film layer disposed between the second base layer and the second barrier layer. The first optical film layer and the second optical film layer are configured to adjust transmittance of the glass panel. Disposing of the first optical film layer and/or the second optical film layer can better reduce impact of the composite film layer on transmittance and hue of the glass panel, so that the glass panel can still have high visible light transmittance after being coated, to meet an application requirement of a display.

In this application, the first optical film layer and the second optical film layer are disposed to adjust and improve optical performance of the composite film layer through thin film interference. The thin film interference is an interference phenomenon generated by two beams of reflected light formed after one beam of light is reflected by two surfaces of a thin film.

In an implementation of this application, a thickness of the first optical film layer ranges from 5 nm to 30 nm, and a thickness of the second optical film layer ranges from 5 nm to 20 nm. Appropriate thicknesses of the first optical film layer and the second optical film layer can effectively improve the optical performance of the composite film layer, optimize the hue and the optical transmittance of the glass panel, and ensure reliable attachment of the first optical film layer and the second optical film layer on a surface of the glass panel.

In an implementation of this application, the first optical film layer and the second optical film layer are laminated structures formed by two or more sublayers, and a material of each sublayer is selected from any one or more of the following: an oxide or a nitride of silicon, aluminum, niobium, titanium, or zirconium, or $SiAl_xO_yN_z$, where values of x, y, and z range from 1 to 6. Preparing an optical film layer by using the foregoing materials can effectively increase visible light transmittance of the composite film layer, to better reduce adverse effects of disposing of the composite film layer on transmittance of the glass panel substrate.

In an implementation of this application, the first optical film layer includes at least one first sublayer and at least one second sublayer that are alternately stacked, and the first sublayer and the second sublayer have different refractive indexes.

In an implementation of this application, the first sublayer comprises 1 to 12 layers, and the second sublayer comprises 1 to 12 layers.

In an implementation of this application, the second optical film layer includes at least one third sublayer and at least one fourth sublayer that are alternately stacked, and the third sublayer and the fourth sublayer have different refractive indexes.

In an implementation of this application, the third sublayer comprises 1 to 12 layers, and the fourth sublayer comprises 1 to 12 layers.

In an implementation of this application, the oxide of silicon includes one or more of $SiO_2$ or $SiO$, and the oxide of aluminum includes $Al_2O_3$. The first base layer and the second base layer are coated with the oxide of silicon and the oxide of aluminum, so that the first base layer and the second base layer can be closely bonded to the surface of the glass panel substrate, and roughness of the surface of the glass panel substrate can be increased, to increase adhesion of a subsequently-coated film layer to the surface of the glass panel substrate.

In an implementation of this application, the oxide of niobium includes one or more of $NbO$, $NbO_2$, $Nb_2O_3$, or $Nb_2O_5$; the oxide of titanium includes $TiO_2$; the oxide of zirconium includes $ZrO_2$; the nitride of silicon includes $Si_3N_4$; the nitride of aluminum includes $AlN$; the nitride of niobium includes one or two of $NbN$ and $Nb_2N$; the nitride of titanium may be $TiN$, $TiN_2$, $Ti_2N$, $Ti_3N$, $Ti_4N$, $Ti_3N_4$, $Ti_3N_5$, or $Ti_5N_6$; and the nitride of zirconium includes $ZrN$.

A diamond-like carbon film (DLC film for short) is an amorphous carbon film that contains a diamond-like structure, basically includes carbon, and has high hardness, high resistivity, and good optical performance. Because of different manners of bonding between carbon atoms, carbon elements may include diamond (Diamond) in which carbon atoms are bonded through sp3 bonds, and graphite (Graphite) in which carbon atoms are bonded through sp2 bonds. In the diamond-like carbon film, carbon atoms are bonded through sp3 and sp2 bonds. The diamond-like carbon film is a metastable amorphous material with long-range disorder, and carbon atoms are bonded through covalent bonds that mainly include two hybrid bonds: sp2 and sp3. The diamond-like carbon film has excellent characteristics of both diamond and graphite.

In an implementation of this application, the diamond-like carbon film layer includes a diamond-like carbon film doped with any one or more doping elements of silicon, aluminum, titanium, zirconium, molybdenum, nitrogen, and hydrogen. Doping the diamond-like carbon film with the foregoing elements can effectively reduce hue impact caused by carbon hybridization, to optimize hue of the entire composite film layer together with the first base layer, the first barrier layer, the second barrier layer, the second base layer, the first optical film layer, and/or the second optical film layer, improve an appearance of the glass panel, and better resolve a problem of poor visual experience caused by a color difference between a detached part and an undetached part of the composite film layer.

In an implementation of this application, an atomic percentage of a non-carbon element at the diamond-like carbon film layer is less than 40%. Appropriately controlling content of the non-carbon element can improve performance of the diamond-like carbon film layer because of doping and better maintain original good performance of the diamond-like carbon film layer.

In an implementation of this application, sp3 hybrid bonds at the diamond-like carbon film layer account for more than 30% of a total quantity of sp2 hybrid bonds and the sp3 hybrid bonds. Controlling content of the sp3 hybrid bonds at the diamond-like carbon film layer to a higher proportion helps obtain higher hardness.

In an implementation of this application, the atomic percentage of the non-carbon element and the proportion of the sp3 hybrid bonds at the diamond-like carbon film layer may be measured by using XPS (X-ray photoelectron spectroscopy, X-ray photoelectron spectroscopy).

In an implementation of this application, Mohs hardness of the glass panel 100 is greater than or equal to 7. A Mineralab Mohs hardness pen is used to scratch a coated surface of the glass panel 100 under a load of 750 g and at 45°. If no visible scratch is found by naked eyes, it is considered that the glass panel 100 passes a corresponding Mohs hardness test of the Mohs hardness pen. The glass panel has high Mohs hardness, to better resist scratching, improve a scratch resistance capability of the glass panel, and improve user experience.

In an implementation of this application, the composite film layer 20 is not detached from the glass panel substrate 10 after more than 10,000 cycles of eraser abrasion. The value is obtained by using a minoan eraser to perform reciprocating abrasion on the coated surface of the glass panel under a load of 1000 g and at a speed of 40 circles/min. A large quantity of cycles of eraser abrasion after which the composite film layer is not detached indicates that the composite film layer has strong adhesion to the glass panel substrate, so that a service life of the composite film layer can be prolonged, and long-term service reliability of the glass panel can be improved.

In an implementation of this application, a value ∆E of a color difference between the glass panel and the glass panel substrate is less than 1.5. In other words, a color difference of the glass panel substrate before and after coating of the composite film layer is very small. The value ∆E of the color difference is a parameter generated as an auxiliary indicator of a Lab value, and usually represents a color difference, namely, a degree of difference between two colors, with a numerical value. A smaller value of ∆E indicates a higher similarity between the two colors. On the contrary, a larger value of ∆E indicates a clearer difference between the two colors. Therefore, ∆E can quantitatively measure a color difference between two colors. ∆E can be calculated according to the following formula:

$$\Delta E = \sqrt{(\triangle L)^2 + (\triangle a)^2 + (\triangle b)^2}$$

Herein, ∆L, ∆a, and ∆b respectively indicate differences between two colors in terms of luminance, a*axis, and b*axis. In other words, the three factors jointly determine a degree of difference between colors. Therefore, a value of ∆E is actually generated based on the three factors.

In an implementation of this application, average transmittance of the glass panel within a wavelength range of 450 nm to 940 nm is greater than or equal to 85%. In embodiments of this application, the glass panel has high optical transmittance, so that a display effect of a display with the glass panel can be improved, and user experience can be improved.

In an implementation of this application, a reduction in transmittance of the glass panel at 550 nm is less than 0.5% relative to the glass panel substrate, or transmittance of the glass panel at 550 nm is greater than or equal to transmittance of the glass panel substrate at 550 nm. According to the glass panel in this application, the composite film layer having a special structure is disposed on the surface of the glass panel substrate. The composite film layer has little impact on the optical transmittance of the glass panel, and may even cause the optical transmittance of the glass panel to be consistent with or higher than the transmittance of the glass panel substrate.

A second aspect of embodiments of this application provides a glass panel preparation method, including: coating a composite film layer on a surface of a glass panel substrate, where the composite film layer includes a first base layer, a first barrier layer, a diamond-like carbon film layer, a second barrier layer, a second base layer, and an anti-fingerprint layer that are sequentially stacked.

The first base layer, the first barrier layer, the diamond-like carbon film layer, the second barrier layer, and the second base layer are prepared through magnetron sputtering, and the anti-fingerprint layer is prepared through evaporation. Materials of the first base layer and the second base layer are independently selected from one or more of an oxide of silicon or an oxide of aluminum, and materials of the first barrier layer and the second barrier layer are independently selected from one or more of $SiN_x$, $CN_x$, $SiC_x$, or $SiN_xC_y$, where values of x and y range from 1 to 6. A thickness of the first base layer ranges from 2 nm to 30 nm, a thickness of the first barrier layer ranges from 1 nm to 20 nm, a thickness of the diamond-like carbon film layer ranges from 3 nm to 40 nm, a thickness of the second barrier layer ranges from 1 nm to 20 nm, a thickness of the second base layer ranges from 2 nm to 30 nm, a thickness of the anti-fingerprint layer is less than or equal to 20 nm, and a thickness of the composite film layer is less than 100 nm.

In an implementation of this application, the composite film layer further includes:
a first optical film layer disposed between the first base layer and the first barrier layer, and/or a second optical film layer disposed between the second base layer and the second barrier layer, where the first optical film layer and the second optical film layer are prepared through magnetron sputtering, and the glass panel preparation method provided in embodiments of this application is simple and easy to control, and can be used to implement large-scale production.

A third aspect of embodiments of this application provides a display, including a display screen module and a glass panel covering the display screen module. The glass panel includes the glass panel according to the first aspect of embodiments of this application. The display with the glass panel in embodiments of this application can better protect the display screen module, and has a better display effect.

Embodiments of this application further provide a terminal, including a housing and a circuit board located inside the housing. The housing includes a display, the display includes a glass panel and a display screen module disposed on an inner side of the glass panel, and the glass panel includes the glass panel according to the first aspect of embodiments of this application. The terminal with the glass panel in embodiments of this application has a good display effect. The terminal may be a terminal device like a mobile phone, a tablet computer, a notebook computer, a wearable product (a watch, a band, or glasses), or a vehicle-mounted device.

BRIEF DESCRIPTION OF DRAWINGS

FIG. 1 is a diagram of a cross-sectional structure of a glass panel 100 according to an embodiment of this application;
FIG. 2 is a diagram of a cross-sectional structure of a glass panel 100 according to another embodiment of this application;
FIG. 3 is a diagram of a cross-sectional structure of a glass panel 100 according to still another embodiment of this application;
FIG. 4 is a diagram of a cross-sectional structure of a glass panel 100 according to yet another embodiment of this application;
FIG. 5 is a diagram of a cross-sectional structure of a first optical film layer 27 according to an embodiment of this application;
FIG. 6 is a diagram of a cross-sectional structure of a second optical film layer 28 according to an embodiment of this application;
FIG. 7 is a diagram of a cross-sectional structure of a display 200 according to an embodiment of this application;
FIG. 8 is a diagram of a cross-sectional structure of a terminal 300 according to an embodiment of this application;
FIG. 9 shows a transmittance curve of a glass panel prepared according to Embodiment 1 of this application;
FIG. 10 shows a transmittance curve of a glass panel prepared according to Embodiment 2 of this application; and
FIG. 11 shows a transmittance curve of a glass panel prepared according to Embodiment 3 of this application.

DESCRIPTION OF EMBODIMENTS

The following describes embodiments of this application with reference to accompanying drawings in embodiments of this application.

Currently, in terminal devices such as a mobile phone, a tablet computer, and a wearable product, a glass panel is used to cover a display component. To improve a scratch resistance capability of the glass panel, a common method in the industry is to coat a protective film on a surface of a glass panel substrate externally. However, an existing externally-coated protective film has the following problems: limited improvement of the scratch resistance capability of the glass panel, easy detachment of the protective film due to insufficient adhesion, a clear color difference before and after coating, a clear reduction in transmittance, and the like. To resolve the foregoing problems to a specific extent, embodiments of this application provide a glass panel. The glass panel is coated with a composite film layer having a specific structure on a surface of a glass panel substrate, so that the glass panel can have high Mohs hardness, to improve a scratch resistance capability of the glass panel. In addition, the composite film layer has strong adhesion to the surface of the substrate and is not easily detached. The composite film layer can further reduce a color difference before and after coating to a specific extent, and increase transmittance.

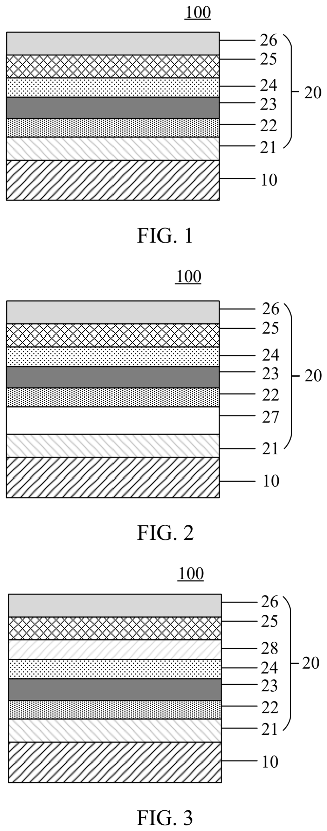

FIG. 1 is a diagram of a cross-sectional structure of a glass panel according to an embodiment of this application. The glass panel 100 provided in this embodiment of this application includes a glass panel substrate 10 and a composite film layer 20 disposed on a surface of the glass panel substrate 10. The composite film layer 20 includes, from the surface of the glass panel substrate 10 to the outside, a first base layer 21, a first barrier layer 22, a diamond-like carbon film layer 23, a second barrier layer 24, a second base layer 25, and an anti-fingerprint layer 26 that are sequentially stacked.

Materials of the first base layer 21 and the second base layer 25 are independently selected from one or more of an oxide of silicon or an oxide of aluminum, and materials of the first barrier layer 22 and the second barrier layer 24 are independently selected from one or more of $SiN_x$, $CN_x$, $SiC_x$, or $SiN_xC_y$, where values of x and y range from 1 to 6. A thickness of the first base layer 21 ranges from 2 nm to 30 nm, a thickness of the first barrier layer 22 ranges from 1 nm to 20 nm, a thickness of the diamond-like carbon film layer 23 ranges from 3 nm to 40 nm, a thickness of the second barrier layer 24 ranges from 1 nm to 20 nm, a thickness of the second base layer 25 ranges from 2 nm to 30 nm, a thickness of the anti-fingerprint layer 26 is less than or equal to 20 nm, and a thickness of the composite film layer 20 is less than 100 nm.

According to the glass panel provided in this embodiment of this application, the composite film layer is coated on the surface of the glass panel substrate, so that the glass panel can have high Mohs hardness, a color difference and a transmittance difference before and after coating are reduced, and the composite film layer has strong adhesion to the surface of the substrate. At the composite film layer, the first base layer is in contact with and stacked on the glass panel substrate. The first base layer can increase adhesion of the composite film layer to the glass panel substrate, to reduce a risk of detachment of the composite film layer, and improve use reliability of the glass panel. The diamond-like carbon film layer has high hardness, and can improve a scratch resistance capability of the glass panel, to help reduce a total specified thickness of the composite film layer. In addition, the diamond-like carbon film layer can further reduce a color difference of the composite film layer before and after coating. Disposing of the first barrier layer and the second barrier layer helps increase overall hardness of the glass panel, and can avoid adverse effects such as oxidation of the diamond-like carbon film layer during preparation of the composite film layer and during use of the glass panel, so that the glass panel can better maintain long-term high hardness. Disposing of the anti-fingerprint layer can reduce residues of fingerprints, stains, and the like during use of the glass panel, and improve user experience. Disposing of the second base layer can increase adhesion of the anti-fingerprint layer, so that the glass panel can maintain long-term anti-smudge performance. In addition, in this application, a total thickness of the composite film layer is controlled to be less than or equal to 100 nm by appropriately controlling a thickness of each layer at the composite film layer to be a small value. Hardness, adhesion, and optical performance can be better balanced under a collaborative action of the film layers, so that stress of the composite film layer is controlled to be at a low level, to effectively avoid a surface shape change of the glass panel substrate and detachment of the composite film layer that are caused by the stress of the film layer, increase the adhesion of the composite film layer to the surface of the glass panel substrate, and prolong a service life of the composite film layer. In this way, a glass panel with excellent comprehensive performance is obtained to better meet a requirement of a terminal device.

In an implementation of this application, the first base layer 21 includes one or more of the oxide of silicon or the oxide of aluminum. The oxide of silicon may be, for example, silicon dioxide ($SiO_2$) or silicon monoxide (SiO). The oxide of aluminum may be, for example, aluminum oxide ($Al_2O_3$). The first base layer 21 is in contact with and connected to the glass panel substrate 10. The first base layer 21 is coated with the oxide of silicon and the oxide of aluminum, so that the first base layer 21 can be closely bonded to the surface of the glass panel substrate 10, and roughness of the surface of the glass panel substrate 10 can be increased, to increase adhesion of a subsequently-coated film layer to the surface of the glass panel substrate 10.

In an implementation of this application, the thickness of the first base layer 21 may range from 2 nm to 30 nm. In some embodiments, the thickness of the first base layer 21 may be, for example, 2 nm, 3 nm, 5 nm, 6 nm, 8 nm, 10 nm, 12 nm, 14 nm, 15 nm, 17 nm, 18 nm, 20 nm, 22 nm, 25 nm, 28 nm, or 30 nm. The first base layer is set to an appropriate thickness and is connected between the glass panel substrate and the first barrier layer, to ensure that a film layer structure disposed on the first base layer is strongly bonded to the glass panel substrate and that the composite film layer can maintain a small total thickness.

In an implementation of this application, the material of the first barrier layer 22 is selected from one or more of $SiN_x$, $CN_x$, $SiC_x$, or $SiN_xC_y$, where the values of x and y range from 1 to 6. Specifically, the values of x and y each may be selected from 1, 2, 3, 4, 5, and 6. The first barrier layer 22 made of the foregoing material can have high hardness, and can better protect the diamond-like carbon film layer from being oxidized or doped with another impurity that affects performance during preparation and use. This also helps set a small thickness for the diamond-like carbon film layer.

In an implementation of this application, the thickness of the first barrier layer 22 ranges from 1 nm to 20 nm. In some embodiments, the thickness of the first barrier layer 22 may be, for example, 1 nm, 2 nm, 3 nm, 5 nm, 6 nm, 8 nm, 10 nm, 12 nm, 14 nm, 15 nm, 17 nm, 18 nm, or 20 nm. A small thickness of the first barrier layer can increase overall adhesion of the composite film layer and improve comprehensive performance of the glass panel.

In some embodiments of this application, the first base layer and the first barrier layer have different refractive indexes, the first base layer is the oxide of silicon, and the first barrier layer is $SiN_x$, $CN_x$, $SiC_x$, or $SiN_xC_y$. In some embodiments of this application, the first base layer is the oxide of aluminum, and the first barrier layer is $SiN_x$, $CN_x$, $SiC_x$, or $SiN_xC_y$.

The diamond-like carbon film (DLC film for short) is an amorphous carbon film that contains a diamond-like structure, basically includes carbon, and has high hardness, high resistivity, and good optical performance. Because of different manners of bonding between carbon atoms, carbon elements may include diamond (Diamond) in which carbon atoms are bonded through sp3 bonds, and graphite (Graphite) in which carbon atoms are bonded through sp2 bonds. In the diamond-like carbon film, carbon atoms are bonded through sp3 and sp2 bonds. The diamond-like carbon film is a metastable amorphous material with long-range disorder, and carbon atoms are bonded through covalent bonds that mainly include two hybrid bonds: sp2 and sp3. The diamond-like carbon film has excellent characteristics of both diamond and graphite.

In an implementation of this application, the diamond-like carbon film layer 23 includes a diamond-like carbon film doped with any one or more elements of silicon, aluminum, titanium, zirconium, molybdenum, nitrogen, and hydrogen. Doping the diamond-like carbon film with the foregoing elements helps increase hardness of the diamond-like carbon film layer and/or reduce hue impact caused by carbon hybridization, optimize hue of the entire composite film layer, improve an appearance and a display effect of the glass panel, and better avoid a problem of poor visual experience caused by a color difference between a detached part and an undetached part of the composite film layer. In some embodiments, the diamond-like carbon film layer 23 includes one doping element. For example, the diamond-like carbon film layer 23 is a nitrogen-doped diamond film layer, a silicon-doped diamond film layer, an aluminum-doped diamond film layer, a titanium-doped diamond film layer, a zirconium-doped diamond film layer, or a molybdenum-doped diamond film layer. In some embodiments, the diamond-like carbon film layer 23 includes two or more doping elements. For example, the diamond-like carbon film layer 23 is a nitrogen and silicon co-doped diamond film layer or a nitrogen and aluminum co-doped diamond film layer.

In an implementation of this application, an atomic percentage of a non-carbon element at the diamond-like carbon film layer is less than 40%. In some embodiments, the atomic percentage of the non-carbon element at the diamond-like carbon film layer ranges from 1% to 40%, for example, 1%, 2%, 5%, 10%, 15%, 20%, 25%, 30%, 35%, or 39%. The non-carbon element includes the foregoing doping elements. Appropriately controlling content of the non-carbon element can improve performance of the diamond-like carbon film layer because of doping and better maintain original good performance of the diamond-like carbon film layer.

In an implementation of this application, sp3 hybrid bonds at the diamond-like carbon film layer account for more than 30% of a total quantity of sp2 hybrid bonds and the sp3 hybrid bonds. In some embodiments, a proportion of the sp3 hybrid bonds is more than 40%, more than 45%, more than 50%, more than 60%, or more than 70%. Controlling content of the sp3 hybrid bonds at the diamond-like carbon film layer to a higher proportion helps obtain higher hardness.

In an implementation of this application, the thickness of the diamond-like carbon film layer 23 ranges from 3 nm to 40 nm. In some embodiments, the thickness of the diamond-like carbon film layer 23 is 3 nm, 5 nm, 10 nm, 15 nm, 20 nm, 25 nm, 30 nm, 35 nm, or 40 nm. Controlling the thickness of the diamond-like carbon film layer within this range can better increase hardness of the glass panel, to improve the scratch resistance capability, and can also keep the total thickness of the composite film layer at a small value, to increase the adhesion of the composite film layer to the surface of the glass panel substrate.

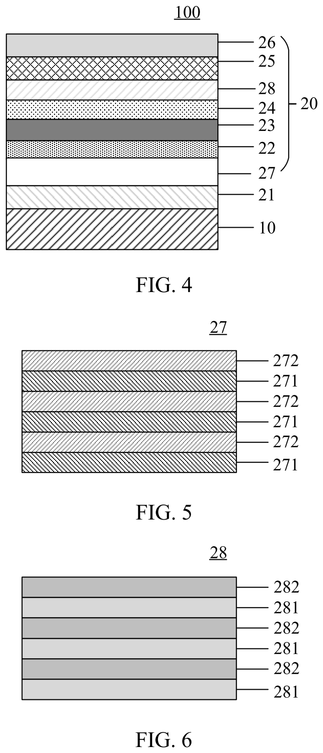

FIG. 2 is a diagram of a cross-sectional structure of the glass panel 100 according to another embodiment of this application. FIG. 3 is a diagram of a cross-sectional structure of the glass panel 100 according to still another embodiment of this application. FIG. 4 is a diagram of a cross-sectional structure of the glass panel 100 according to yet another embodiment of this application. In an implementation of this application, the composite film layer 20 further includes a first optical film layer 27 disposed between the first base layer 21 and the first barrier layer 22, and/or a second optical film layer 28 disposed between the second base layer 25 and the second barrier layer 24. The first optical film layer 27 and the second optical film layer 28 are configured to adjust transmittance of the glass panel. Disposing of the first optical film layer and/or the second optical film layer can better reduce impact of the composite film layer on transmittance and hue of the glass panel, so that the glass panel can still have high visible light transmittance after being coated, to meet an application requirement of a display.

In this application, the first optical film layer and the second optical film layer are disposed to adjust and improve optical performance of the composite film layer through thin film interference. The thin film interference is an interference phenomenon generated by two beams of reflected light formed by reflecting one beam of light via two surfaces of a thin film.

In some embodiments of this application, as shown in FIG. 2, the composite film layer 20 includes the first optical film layer 27 disposed between the first base layer 21 and the first barrier layer 22, and does not include the second optical film layer 28. In some embodiments of this application, as shown in FIG. 3, the composite film layer 20 includes the second optical film layer 28 disposed between the second base layer 25 and the second barrier layer 24, and does not include the first optical film layer 27. In some embodiments of this application, as shown in FIG. 4, the composite film layer 20 includes both the first optical film layer 27 disposed between the first base layer 21 and the first barrier layer 22 and the second optical film layer 28 disposed between the second base layer 25 and the second barrier layer 24.

In this application, the first optical film layer 27 and the second optical film layer 28 are disposed to adjust and improve optical performance of the composite film layer 20 through thin film interference. The thin film interference is an interference phenomenon generated by two beams of reflected light formed by reflecting one beam of light via two surfaces of a thin film.

In an implementation of this application, both the first optical film layer 27 and the second optical film layer 28 are laminated structures formed by two or more sublayers, and a material of each sublayer is selected from any one or more of the following: an oxide or a nitride of silicon, aluminum, niobium, titanium, or zirconium, or $SiAl_xO_yN_z$, where values of x, y, and z range from 1 to 6. The first optical film layer 27 and the second optical film layer 28 may include two or more materials with different refractive indexes, to form two or more sublayers with different refractive indexes. The oxide of silicon may be, for example, silicon dioxide ($SiO_2$) or silicon monoxide (SiO). The oxide of aluminum may be, for example, aluminum oxide ($Al_2O_3$). The oxide of niobium may be niobium monoxide, niobium dioxide, niobium trioxide, niobium pentoxide, or a mixture of two or more thereof. The oxide of titanium may be titanium dioxide. The oxide of zirconium may be zirconium dioxide. The nitride of silicon may be silicon nitride $Si_3N_4$, the nitride of aluminum may be aluminum nitride AlN, the nitride of niobium may be NbN or $Nb_2N$, the nitride of titanium may be TiN, $TiN_2$, $Ti_2N$, $Ti_3N$, $Ti_4N$, $Ti_3N_4$, $Ti_3N_5$ or $Ti_5N_6$, and the nitride of zirconium may be ZrN. The values of x, y, and z in $SiAl_xO_yN_z$ each may be selected from 1, 2, 3, 4, 5, and 6. Preparing an optical film layer by using the foregoing materials can effectively increase visible light transmittance of the composite film layer, to better reduce adverse effects of disposing of the composite film layer on transmittance of the glass panel substrate.

FIG. 5 is a diagram of a cross-sectional structure of the first optical film layer 27 according to an embodiment of this application. The first optical film layer 27 includes at least one first sublayer 271 and at least one second sublayer 272 that are alternately stacked, and a refractive index of the first sublayer 271 is different from a refractive index of the second sublayer 272. For example, the refractive index of the first sublayer 271 may be less than the refractive index of the second sublayer 272. The first optical film layer 27 may be in contact with the first base layer 21 through the first sublayer 271 or the second sublayer 272. The first optical film layer 27 may be in contact with the first barrier layer 22 through the first sublayer 271 or the second sublayer 272. In this application, the first optical film layer 27 may include 1 to 12 first sublayers 271 and 1 to 12 second sublayers 272. The 1 to 12 layers may be specifically, for example, 1 layer, 2 layers, 3 layers, 4 layers, 5 layers, 6 layers, 7 layers, 8 layers, 9 layers, 10 layers, 11 layers, or 12 layers. A quantity of first sublayers 271 may be the same as or different from a quantity of second sublayers 272. It may be understood that materials of the first sublayer 271 and the second sublayer 272 may be selected from any one or more of the following: the oxide or the nitride of silicon, aluminum, niobium, titanium, or zirconium, or $SiAl_xO_yN_z$. In some embodiments, the first sublayer 271 is silicon nitride $Si_3N_4$, and the second sublayer 272 is silicon dioxide $SiO_2$. In some embodiments, the first sublayer 271 is silicon nitride $Si_3N_4$, and the second sublayer 272 is aluminum oxide $Al_2O_3$.

FIG. 6 is a diagram of a cross-sectional structure of the second optical film layer 28 according to an embodiment of this application. The second optical film layer 28 includes at least one third sublayer 281 and at least one fourth sublayer 282 that are alternately stacked, and a refractive index of the third sublayer 281 is different from a refractive index of the fourth sublayer 282. For example, the refractive index of the third sublayer 281 may be less than the refractive index of the fourth sublayer 282. The second optical film layer 28 may be in contact with the second base layer 25 through the third sublayer 281 or the second sublayer 272. The second optical film layer 28 may be in contact with the second barrier layer 24 through the third sublayer 281 or the fourth sublayer 282. In this application, the second optical film layer 28 may include 1 to 12 third sublayers 281 and 1 to 12 fourth sublayers 282. The 1 to 12 layers may be specifically, for example, 1 layer, 2 layers, 3 layers, 4 layers, 5 layers, 6 layers, 7 layers, 8 layers, 9 layers, 10 layers, 11 layers, or 12 layers. A quantity of third sublayers 281 may be the same as or different from a quantity of fourth sublayers 282. It may be understood that materials of the third sublayer 281 and the fourth sublayer 282 may be selected from any one or more of the following: the oxide or the nitride of silicon, aluminum, niobium, titanium, or zirconium, or $SiAl_xO_yN_z$. In some embodiments, the third sublayer 281 is silicon nitride $Si_3N_4$, and the fourth sublayer 282 is silicon dioxide $SiO_2$. In some embodiments, the third sublayer 281 is silicon nitride $Si_3N_4$, and the fourth sublayer 282 is aluminum oxide $Al_2O_3$.

In this application, when the composite film layer 20 includes both the first optical film layer 27 and the second optical film layer 28, the first optical film layer 27 and the second optical film layer 28 may have a same composition structure, or may have different composition structures. The first optical film layer 27 and the second optical film layer 28 may include a same quantity of sublayers or different quantities of sublayers. Thicknesses of the first optical film layer 27 and the second optical film layer 28 may be the same or different.

In an implementation of this application, the thickness of the first optical film layer 27 ranges from 5 nm to 30 nm. In some embodiments, the thickness of the first optical film layer 27 is 5 nm, 6 nm, 8 nm, 10 nm, 12 nm, 15 nm, 18 nm, 20 nm, 22 nm, 25 nm, or 30 nm. An appropriate thickness of the first optical film layer can effectively improve the optical performance of the composite film layer, optimize the hue and the optical transmittance of the glass panel, and ensure reliable attachment of the first optical film layer on a surface of the glass panel.

In an implementation of this application, the thickness of the second optical film layer 28 ranges from 5 nm to 20 nm. In some embodiments, the thickness of the second optical film layer 28 is 5 nm, 6 nm, 8 nm, 10 nm, 12 nm, 15 nm, 18 nm, or 20 nm. An appropriate thickness of the second optical film layer can effectively improve the optical performance of the composite film layer, optimize the hue and the optical transmittance of the glass panel, and ensure reliable attachment of the second optical film layer on the surface of the glass panel.

In an implementation of this application, the second base layer 25 includes one or more of the oxide of silicon or the oxide of aluminum. The oxide of silicon may be, for example, silicon dioxide ($SiO_2$) or silicon monoxide (SiO). The oxide of aluminum may be, for example, aluminum oxide ($Al_2O_3$). The second base layer 25 is in contact with and connected to the anti-fingerprint layer 26. The second base layer 25 is coated with the oxide of silicon and the oxide of aluminum, so that the anti-fingerprint layer 26 can be closely bonded to the glass panel substrate.

In an implementation of this application, the thickness of the second base layer 25 may range from 2 nm to 30 nm. In some embodiments, the thickness of the second base layer 25 may be, for example, 2 nm, 3 nm, 5 nm, 6 nm, 8 nm, 10 nm, 12 nm, 14 nm, 15 nm, 17 nm, 18 nm, 20 nm, 22 nm, 25 nm, 28 nm, or 30 nm. The second base layer is set to an appropriate thickness, to ensure that the anti-fingerprint layer is strongly bonded to the glass panel substrate and that the composite film layer can maintain a small total thickness.

In an implementation of this application, the material of the second barrier layer 24 is selected from one or more of $SiN_x$, $CN_x$, $SiC_x$, or $SiN_xC_y$, where the values of x and y range from 1 to 6. Specifically, the values of x and y each may be selected from 1, 2, 3, 4, 5, and 6. The second barrier layer 24 made of the foregoing material can have high hardness, and can better protect the diamond-like carbon film layer from being oxidized or doped with another impurity that affects performance during use. This also helps set a small thickness for the diamond-like carbon film layer.

In an implementation of this application, the thickness of the second barrier layer 24 ranges from 1 nm to 20 nm. In some embodiments, the thickness of the second barrier layer 24 may be, for example, 1 nm, 2 nm, 3 nm, 5 nm, 6 nm, 8 nm, 10 nm, 12 nm, 14 nm, 15 nm, 17 nm, 18 nm, or 20 nm. A small thickness of the second barrier layer can increase overall adhesion of the composite film layer and improve comprehensive performance of the glass panel.

In some embodiments of this application, the second base layer and the second barrier layer have different refractive indexes, the second base layer is the oxide of silicon, and the second barrier layer is $SiN_x$, $CN_x$, $SiC_x$, or $SiN_xC_y$. In some embodiments of this application, the second base layer is the oxide of aluminum, and the second barrier layer is $SiN_x$, $CN_x$, $SiC_x$, or $SiN_xC_y$.

In the composite film layer 20 of this application, materials and thicknesses of the first base layer 21 and the second base layer 25 may be the same or different. Materials and thicknesses of the first barrier layer 22 and the second barrier layer 24 may be the same or different.

In an implementation of this application, a material of the anti-fingerprint layer 26 is not limited, provided that an anti-fingerprint effect can be implemented. For example, the material of the anti-fingerprint layer 26 may be a fluorine-containing material. The fluorine-containing material may be, for example, perfluoropolyether.

In an implementation of this application, the thickness of the anti-fingerprint layer 26 is less than or equal to 20 nm. In some embodiments, the thickness of the anti-fingerprint layer 26 ranges from 3 nm to 20 nm. In some embodiments, the thickness of the anti-fingerprint layer 26 is 3 nm, 5 nm, 6 nm, 8 nm, 10 nm, 12 nm, 15 nm, 18 nm, or 20 nm. Controlling the thickness of the anti-fingerprint layer to be a small value can better control the total thickness of the composite film layer to be a small value, to increase the adhesion of the composite film layer to the surface of the glass panel substrate.

In an implementation of this application, the thickness of the composite film layer 20 is less than 100 nm. In some embodiments, the thickness of the composite film layer 20 is 10 nm, 20 nm, 30 nm, 40 nm, 50 nm, 55 nm, 60 nm, 65 nm, 70 nm, 75 nm, 80 nm, 85 nm, 90 nm, 95 nm, or 100 nm. The total thickness of the composite film layer is controlled to be less than or equal to 100 nm, so that stress of the composite film layer can be controlled to be at a low level, to effectively avoid a surface shape change of the glass panel substrate and detachment of the composite film layer that are caused by the stress of the film layer, increase the adhesion of the composite film layer to the surface of the glass panel substrate, and prolong a service life of the composite film layer. In addition, an appearance color difference before and after coating of the glass panel can be minimized, to improve user experience.

In an implementation of this application, the glass panel substrate 10 may be microcrystalline glass or common glass. To improve mechanical properties and the like of the glass panel, chemically-strengthened microcrystalline glass or chemically-strengthened common glass may be used. A thickness, a performance parameter, and the like of the glass panel substrate 10 may be selected based on an actual requirement.

In an implementation of this application, Mohs hardness of the glass panel 100 is greater than or equal to 7. A Mineralab Mohs hardness pen is used to scratch a coated surface of the glass panel 100 under a load of 750 g and at 45°. If no visible scratch is found by naked eyes, it is considered that the glass panel 100 passes a corresponding Mohs hardness test of the Mohs hardness pen. The glass panel has high Mohs hardness, to better resist scratching, improve a scratch resistance capability of the glass panel, and improve user experience.

In an implementation of this application, the composite film layer 20 is not detached from the glass panel substrate 10 after more than 10,000 cycles of eraser abrasion. The value is obtained by using a minoan eraser to perform reciprocating abrasion on the coated surface of the glass panel under a load of 1000 g and at a speed of 40 circles/min. A large quantity of cycles of eraser abrasion after which the composite film layer is not detached indicates that the composite film layer has strong adhesion to the glass panel substrate, so that a service life of the composite film layer can be prolonged, and long-term service reliability of the glass panel can be improved.

In an implementation of this application, a value $\Delta E$ of a color difference between the glass panel 100 and the glass panel substrate 10 is less than 1.5. In some implementations, a value $\Delta E$ of a color difference between the glass panel 100 and the glass panel substrate 10 is less than 1.0. In an implementation of this application, a value $\Delta E$ of a color difference between the glass panel 100 and the glass panel substrate 10 is less than 0.5. In other words, the color difference of the glass panel substrate before and after coating of the composite film layer is very small. The value ΔE of the color difference is a parameter generated as an auxiliary indicator of a Lab value, and usually represents a color difference, namely, a degree of difference between two colors, with a numerical value. A smaller value of ΔE indicates a higher similarity between the two colors. On the contrary, a larger value of ΔE indicates a clearer difference between the two colors. Therefore, ΔE can quantitatively measure a color difference between two colors. ΔE can be calculated according to the following formula:

$$\Delta E = \sqrt{(\triangle L)^2 + (\triangle a)^2 + (\triangle b)^2}$$

Herein, ΔL, Δa, and Δb respectively indicate differences between two colors in terms of luminance, a*axis, and b*axis. In other words, the three factors jointly determine a degree of difference between colors. Therefore, a value of ΔE is actually generated based on the three factors.

In an implementation of this application, average transmittance of the glass panel 100 within a wavelength range of 450 nm to 940 nm is greater than or equal to 85%. In some embodiments, average transmittance of the glass panel 100 within a wavelength range of 450 nm to 940 nm is greater than or equal to 88%. In some embodiments, average transmittance of the glass panel 100 within a wavelength range of 450 nm to 940 nm is greater than or equal to 90%. In embodiments of this application, the glass panel has high optical transmittance, so that a display effect of a display with the glass panel can be improved, and user experience can be improved.

In an implementation of this application, a reduction in transmittance of the glass panel 100 at 550 nm is less than 0.5% relative to the glass panel substrate 10. A reduction in transmittance of the glass panel 100 at 550 nm is less than 0.3% relative to the glass panel substrate 10. In some implementations of this application, transmittance of the glass panel at 550 nm is greater than or equal to transmittance of the glass panel substrate at 550 nm. According to the glass panel in this application, the composite film layer having a special structure is disposed on the surface of the glass panel substrate. The composite film layer has little impact on the optical transmittance of the glass panel, and may even cause the optical transmittance of the glass panel to be consistent with or higher than the transmittance of the glass panel substrate. In this case, the glass panel still has high transmittance after the composite film layer is coated.

The glass panel in this embodiment of this application has high Mohs hardness, and a small color difference and a small transmittance difference before and after coating, and the composite film layer has strong adhesion to the surface of the substrate. Therefore, the glass panel may be used in the display of the terminal device to improve product competitiveness.

Embodiments of this application further provide a glass panel preparation method, including:

coating a composite film layer on a surface of a glass panel substrate, where the composite film layer includes a first base layer, a first barrier layer, a diamond-like carbon film layer, a second barrier layer, a second base layer, and an anti-fingerprint layer that are sequentially stacked.

The first base layer, the first barrier layer, the diamond-like carbon film layer, the second barrier layer, and the second base layer are prepared through magnetron sputtering, and the anti-fingerprint layer is prepared through evaporation.

In an implementation of this application, the composite film layer further includes a first optical film layer disposed between the first base layer and the first barrier layer, and/or a second optical film layer disposed between the second base layer and the second barrier layer. The first optical film layer and the second optical film layer are prepared through magnetron sputtering.

In an implementation of this application, the glass panel preparation method may include:

placing a cleaned glass panel substrate into a sputtering coating machine, first coating a first base layer on a surface of the glass panel substrate, then coating a first barrier layer on the first base layer, then coating a nitrogen-doped diamond-like carbon film layer on the first barrier layer, then coating a second barrier layer on the nitrogen-doped diamond-like carbon film layer, coating a second base layer on the second barrier layer, and finally depositing an AF anti-fingerprint layer on the second base layer through evaporation, to obtain a glass panel.

The glass panel preparation method provided in this embodiment of this application is simple and easy to control, and can be used to implement large-scale production.

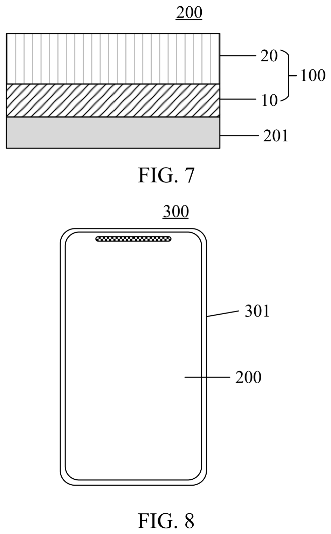

FIG. 7 is a diagram of a cross-sectional structure of a display 200 according to an embodiment of this application. The display 200 provided in this embodiment of this application includes a display screen module 201 and a glass panel 100 covering the display screen module. A glass panel substrate 10 of the glass panel 100 is in direct contact with the display screen module 201. The glass panel 100 is configured to provide protection for the display screen module 201, and may also be touched by a user. The display with the glass panel in this embodiment of this application can better protect the display screen module, and has a better display effect.

FIG. 8 is a diagram of a cross-sectional structure of a terminal 300 according to an embodiment of this application. The terminal 300 provided in this embodiment of this application includes a housing 301 and a circuit board (not shown in FIG. 8) located inside the housing 301. The housing 301 includes a display 200, the display 200 includes a glass panel 100 and a display screen module 201 disposed on an inner side of the glass panel 100. The terminal with the glass panel in this embodiment of this application has a good display effect. The terminal may be a terminal device like a mobile phone, a tablet computer, a notebook computer, a wearable product (a watch, a band, or glasses), or a vehicle-mounted device.

Embodiments of this application are further described below by using a plurality of embodiments.

Transmittance and a color difference are tested by using an optical test device like a CM3600a. In a hardness test, a Mineralab Mohs hardness pen is used to scratch a coated surface of the glass panel under a load of 750 g and at 45°. If no visible scratch is found by naked eyes, it is considered that the glass panel passes a corresponding Mohs hardness test of the Mohs hardness pen. In an abrasion resistance test, a minoan eraser is used to perform reciprocating abrasion on the coated surface of the glass panel under a load of 1000 g and at a speed of 40 circles/min. One round of reciprocating abrasion is recorded as one abrasion cycle.

Embodiment 1

A cleaned glass panel substrate is placed into a sputtering coating machine. First, a $SiO_2$ base layer with a thickness of 6 nm is coated on a surface of the glass panel substrate. Then, a first optical film layer and a first barrier layer that are in a stacked structure $Si_3N_4/SiO_2/Si_3N_4/SiO_2/Si_3N_4$ are coated on the base layer. A total thickness of the first optical film layer and the first barrier layer is 30 nm. Then, a nitrogen-doped diamond-like carbon film layer with a thickness of 20 nm is coated on the first optical film layer. Then, a second optical film layer, a second barrier layer, and a second base layer that are in a stacked structure $Si_3N_4/SiO_2/Si_3N_4/SiO_2$ are coated on the nitrogen-doped diamond-like carbon film layer. A total thickness of the second optical film layer, the second barrier layer, and the second base layer is 20 nm. Finally, an AF anti-fingerprint layer with a thickness of 8 nm is deposited on the second optical film layer through evaporation to obtain a glass panel. A stacked structure of the glass panel is glass/$SiO_2$/$Si_3N_4$/$SiO_2$/$Si_3N_4$/$SiO_2$/$Si_3N_4$/nitrogen-doped diamond-like carbon film layer/$Si_3N_4$/$SiO_2$/$Si_3N_4$/$SiO_2$/AF.

A performance test is as follows:

1. Transmittance:

| Wavelength | 450 nm | 550 nm | 650 nm | 750 nm | 850 nm | 940 nm |
|---|---|---|---|---|---|---|
| Transmittance after coating | 91.4% | 91.6% | 91.8% | 91.9% | 92.2% | 92.3% |
| Transmittance before coating | 89.9% | 90.8% | 91.2% | 91.5% | 92% | 92.1% |

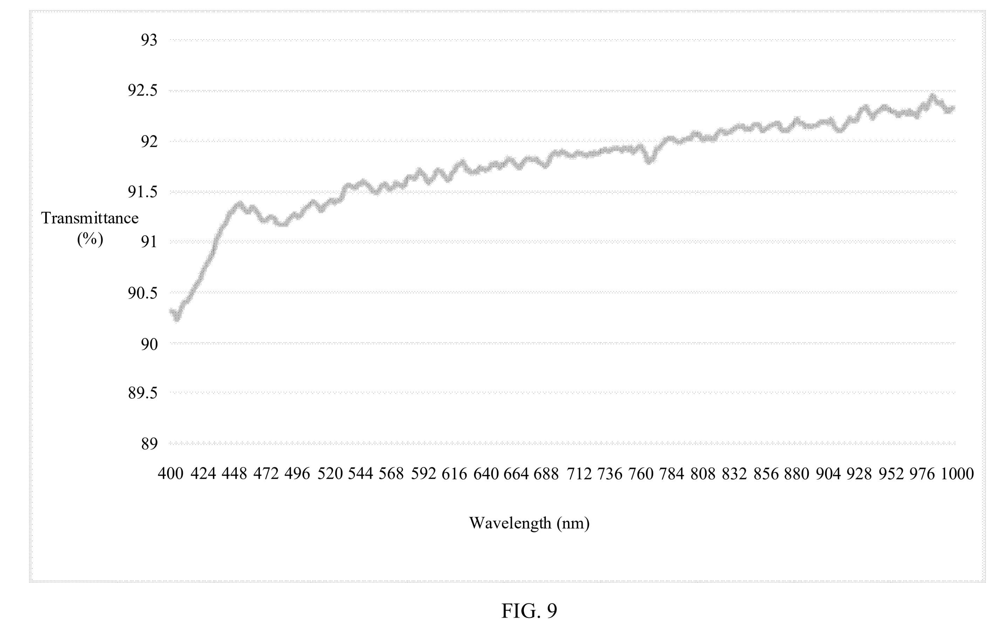

FIG. 9 shows a transmittance curve of the glass panel prepared according to Embodiment 1.

2. Hardness test:

Mohs hardness 6 passed, Mohs hardness 7 passed, and Mohs hardness 8 failed.

3. Abrasion resistance test:

Resistant to more than 10,000 cycles of eraser abrasion

4. Color difference test:

Test result: A color difference before and after coating is less than 0.5.

Embodiment 2

A cleaned glass panel substrate is placed into a sputtering coating machine. First, a $SiO_2$ base layer with a thickness of 15 nm is coated on a surface of the glass panel substrate. Then, a first optical film layer and a first barrier layer that are in a stacked structure $Si_3N_4/Al_2O_3/Si_3N_4/Al_2O_3/Si_3N_4$ are coated on the base layer. A total thickness of the first optical film layer and the first barrier layer is 20 nm. Then, a nitrogen-doped diamond-like carbon film layer with a thickness of 20 nm is coated on the first optical film layer. Then, a second optical film layer, a second barrier layer, and a second base layer that are in a stacked structure $Si_3N_4/Al_2O_3/Si_3N_4/Al_2O_3$ are coated on the nitrogen-doped diamond-like carbon film layer. A total thickness of the second optical film layer, the second barrier layer, and the second base layer is 15 nm. Finally, an AF anti-fingerprint layer with a thickness of 10 nm is deposited on the second optical film layer through evaporation to obtain a glass panel. A stacked structure of the glass panel is glass/$SiO_2$/$Si_3N_4$/$Al_2O_3$/$Si_3N_4$/$Al_2O_3$/$Si_3N_4$/nitrogen-doped diamond-like carbon film layer/$Si_3N_4$/$Al_2O_3$/$Si_3N_4$/$Al_2O_3$/AF.

A performance test is as follows:

1. Transmittance test:

| Wavelength | 450 nm | 550 nm | 650 nm | 750 nm | 850 nm | 940 nm |
|---|---|---|---|---|---|---|
| Transmittance after coating | 88.2% | 90.8% | 91.6% | 92.0% | 92.5% | 92.6% |

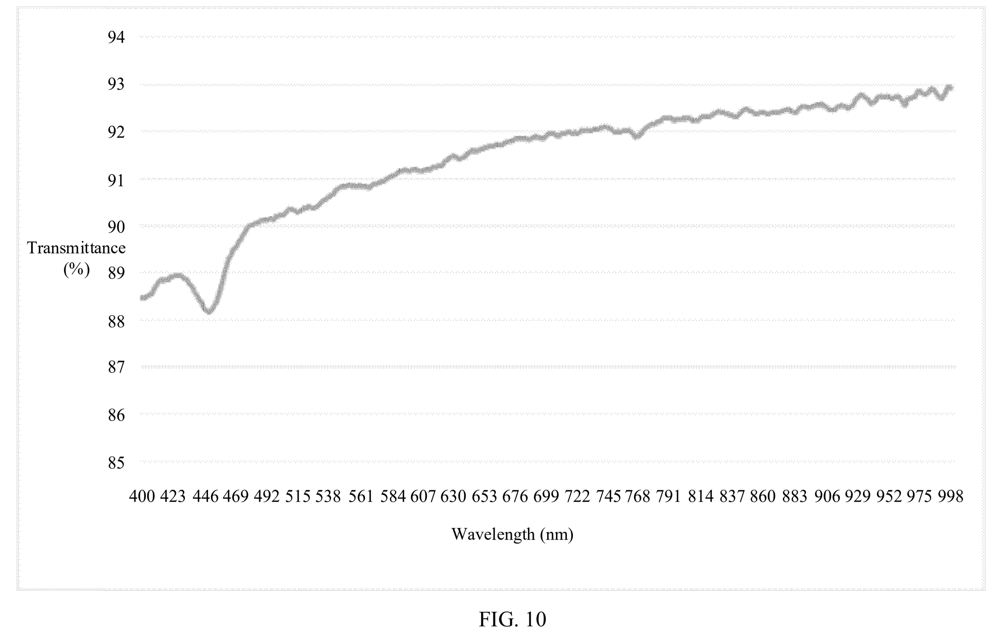

FIG. 10 shows a transmittance curve of the glass panel prepared according to Embodiment 2.

2. Hardness test:

Mohs hardness 6 passed, Mohs hardness 7 passed, and Mohs hardness 8 failed.

3. Abrasion resistance test:

Resistant to more than 10,000 cycles of eraser abrasion

4. Color difference test:

Test result: A color difference before and after coating is less than 0.5.

Embodiment 3

A cleaned glass panel substrate is placed into a sputtering coating machine. First, a first $SiO_2$ base layer with a thickness of 10 nm is coated on a surface of the glass panel substrate. Then, a first SiC barrier layer is coated on the first base layer. A thickness of the first barrier layer is 20 nm. Then, a nitrogen-doped diamond-like carbon film layer with a thickness of 10 nm is coated on the first barrier layer. Then, a second barrier layer and a second base layer that are in a stacked structure SiC/$SiO_2$ are coated on the nitrogen-doped diamond-like carbon film layer. A total thickness of the second barrier layer and the second base layer is 10 nm. Finally, an AF anti-fingerprint layer with a thickness of 15 nm is deposited on the second base layer through evaporation to obtain a glass panel. A stacked structure of the glass panel is glass/$SiO_2$/SiC/nitrogen-doped diamond-like carbon film layer/SiC/$SiO_2$/AF.

A performance test is as follows:

1. Transmittance test:

| Wavelength | 450 nm | 550 nm | 650 nm | 750 nm | 850 nm | 940 nm |
|---|---|---|---|---|---|---|
| Transmittance after coating | 86.8% | 88.7% | 89.9% | 90.7% | 91.4% | 92.1% |

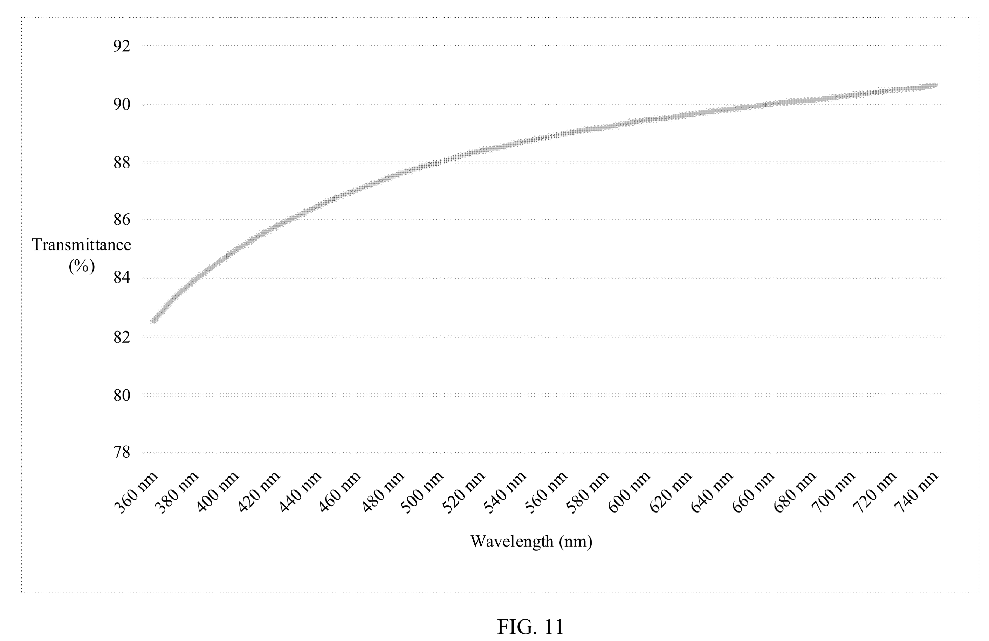

FIG. 11 shows a transmittance curve of the glass panel prepared according to Embodiment 3.

2. Hardness test:

Mohs hardness 6 passed, Mohs hardness 7 passed, and Mohs hardness 8 failed.

3. Abrasion resistance test:

Resistant to more than 10,000 cycles of eraser abrasion

4. Color difference test:

Test result: A color difference before and after coating is less than 0.5.

It can be learned from the foregoing results that, according to the glass panel in this embodiment of this application, a composite film layer that has a specific structure and whose thickness is less than 100 nm is disposed on a surface of a glass panel substrate. Transmittance of the glass panel changes slightly before and after coating, and the glass panel still has high transmittance after the composite film layer is coated. This indicates that the composite film layer in this embodiment of this application has small impact on the transmittance of the glass panel. The composite film layer has high Mohs hardness, and can improve a scratch resistance capability of the glass panel. The composite film layer has strong adhesion to the glass panel substrate, and the composite film layer is not detached after more than 10,000 cycles of eraser abrasion. In this way, the composite film layer can be firmly bonded to the surface of the glass panel substrate in a service process, and can provide long-term protection for the substrate.

It should be understood that "first", "second", and various numbers in this specification are merely used for differentiation for ease of description, but are not intended to limit the scope of this application.

In this application, "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated objects.

In this application, "at least one" means one or more, and "a plurality of" means two or more. "At least one of the following items (pieces)" or a similar expression thereof refers to any combination of these items, including a single item (piece) or any combination of a plurality of items (pieces). For example, "at least one of a, b, or c", or "at least one of a, b, and c" may indicate: a, b, c, a-b (namely, a and b), a-c, b-c, or a-b-c, where a, b, and c may be singular or plural.

In this application, "-" indicates a range value, including endpoint values at two ends. For example, a value of a may be 0.5-15, indicating that the value of a may range from 0.5 to 15, and endpoint values 0.5 and 15 are included.

It should be understood that sequence numbers of the foregoing processes do not mean an execution sequence in various embodiments of this application. A part or all of the steps may be performed in parallel or in sequence. The execution sequence of the processes should be determined based on functions and internal logic of the processes, and should not be construed as any limitation on the implementation processes of embodiments of this application.

**Claims**

1. A glass panel, comprising a glass panel substrate and a composite film layer disposed on a surface of the glass panel substrate, wherein the composite film layer comprises a first base layer, a first barrier layer, a diamond-like carbon film layer, a second barrier layer, a second base layer, and an anti-fingerprint layer that are sequentially stacked; and materials of the first base layer and the second base layer are independently selected from one or more of an oxide of silicon or an oxide of aluminum, and materials of the first barrier layer and the second barrier layer are independently selected from one or more of $SiN_x$, $CN_x$, $SiC_x$, or $SiN_xC_y$, wherein values of x and y range from 1 to 6; and a thickness of the first base layer ranges from 2 nm to 30 nm, a thickness of the first barrier layer ranges from 1 nm to 20 nm, a thickness of the diamond-like carbon film layer ranges from 3 nm to 40 nm, a thickness of the second barrier layer ranges from 1 nm to 20 nm, a thickness of the second base layer ranges from 2 nm to 30 nm, a thickness of the anti-fingerprint layer is less than or equal to 20 nm, and a thickness of the composite film layer is less than 100 nm.

2. The glass panel according to claim 1, wherein the composite film layer further comprises a first optical film layer disposed between the first base layer and the first barrier layer, and/or a second optical film layer disposed between the second base layer and the second barrier layer, wherein the first optical film layer and the second optical film layer are configured to adjust transmittance of the glass panel.

3. The glass panel according to claim 2, wherein a thickness of the first optical film layer ranges from 5 nm to 30 nm, and a thickness of the second optical film layer ranges from 5 nm to 20 nm.

4. The glass panel according to claim 2 or 3, wherein the first optical film layer and the second optical film layer are laminated structures formed by two or more sublayers, and a material of each sublayer is selected from any one or more of the following: an oxide or a nitride of silicon, aluminum, niobium, titanium, or zirconium, or $SiAl_xO_yN_z$, wherein values of x, y, and z range from 1 to 6.

5. The glass panel according to claim 4, wherein the first optical film layer comprises at least one first sublayer and at least one second sublayer that are alternately stacked, and the first sublayer and the second sublayer have different refractive indexes.

6. The glass panel according to claim 5, wherein the first sublayer comprises 1 to 12 layers, and the second sublayer comprises 1 to 12 layers.

7. The glass panel according to claim 4, wherein the second optical film layer comprises at least one third sublayer and at least one fourth sublayer that are alternately stacked, and the third sublayer and the fourth sublayer have different refractive indexes.

8. The glass panel according to claim 7, wherein the third sublayer comprises 1 to 12 layers, and the fourth sublayer comprises 1 to 12 layers.

9. The glass panel according to any one of claims 1 to 8, wherein the oxide of silicon comprises one or more of $SiO_2$ or $SiO$, and the oxide of aluminum comprises $Al_2O_3$.

10. The glass panel according to any one of claims 4 to 8, wherein the oxide of niobium comprises one or more of $NbO$, $NbO_2$, $Nb_2O_3$, and $Nb_2O_5$; the oxide of titanium comprises $TiO_2$; the oxide of zirconium comprises $ZrO_2$; the nitride of silicon comprises $Si_3N_4$; the nitride of aluminum comprises $AlN$; the nitride of niobium comprises one or two of $NbN$ and $Nb_2N$; the nitride of titanium comprises $TiN$, $TiN_2$, $Ti_2N$, $Ti_3N$, $Ti_4N$, $Ti_3N_4$, $Ti_3N_5$, or $Ti_5N_6$; and the nitride of zirconium comprises $ZrN$.

11. The glass panel according to any one of claims 1 to 10, wherein the diamond-like carbon film layer comprises a diamond-like carbon film doped with any one or more doping elements of silicon, aluminum, titanium, zirconium, molybdenum, nitrogen, and hydrogen.

12. The glass panel according to any one of claims 1 to 11, wherein an atomic percentage of a non-carbon element at the diamond-like carbon film layer is less than 40%.

13. The glass panel according to any one of claims 1 to 12, wherein sp3 hybrid bonds at the diamond-like carbon film layer account for more than 30% of a total quantity of sp2 hybrid bonds and the sp3 hybrid bonds.

14. The glass panel according to any one of claims 1 to 13, wherein Mohs hardness of the glass panel is greater than or equal to 7.

15. The glass panel according to any one of claims 1 to 14, wherein the composite film layer is not detached from the glass panel substrate after more than 10,000 cycles of eraser abrasion.

16. The glass panel according to any one of claims 1 to 15, wherein a value $\Delta E$ of a color difference between the glass panel and the glass panel substrate is less than 1.5.

17. The glass panel according to any one of claims 1 to 16, wherein average transmittance of the glass panel within a wavelength range of 450 nm to 940 nm is greater than or equal to 85%.

18. The glass panel according to any one of claims 1 to 17, wherein a reduction in transmittance of the glass panel at 550 nm is less than 0.5% relative to the glass panel substrate, or transmittance of the glass panel at 550 nm is greater than or equal to transmittance of the glass panel substrate at 550 nm.

19. A glass panel preparation method, comprising:

coating a composite film layer on a surface of a glass panel substrate, wherein the composite film layer comprises a first base layer, a first barrier layer, a diamond-like carbon film layer, a second barrier layer, a second base layer, and an anti-fingerprint layer that are sequentially stacked, wherein
the first base layer, the first barrier layer, the diamond-like carbon film layer, the second barrier layer, and the second base layer are prepared through magnetron sputtering, and the anti-fingerprint layer is prepared through evaporation; materials of the first base layer and the second base layer are independently selected from one or more of an oxide of silicon or an oxide of aluminum, and materials of the first barrier layer and the second barrier layer are independently selected from one or more of $SiN_x$, $CN_x$, $SiC_x$, or $SiN_xC_y$, wherein values of x and y range from 1 to 6; and a thickness of the first base layer ranges from 2 nm to 30 nm, a thickness of the first barrier layer ranges from 1 nm to 20 nm, a thickness of the diamond-like carbon film layer ranges from 3 nm to 40 nm, a thickness of the second barrier layer ranges from 1 nm to 20 nm, a thickness of the second base layer ranges from 2 nm to 30 nm, a thickness of the anti-fingerprint layer is less than or equal to 20 nm, and a thickness of the composite film layer is less than 100 nm.

20. The preparation method according to claim 19, wherein the composite film layer further comprises:
a first optical film layer disposed between the first base layer and the first barrier layer, and/or a second optical film layer disposed between the second base layer and the second barrier layer, wherein the first optical film layer and the second optical film layer are prepared through magnetron sputtering.

21. A display, comprising a display screen module and a glass panel covering the display screen module, wherein the glass panel comprises the glass panel according to any one of claims 1 to 18.

22. A terminal, comprising a housing and a circuit board located inside the housing, wherein the housing comprises a display, the display comprises a glass panel and a display screen module disposed on an inner side of the glass panel, and the glass panel comprises the glass panel according to any one of claims 1 to 18.

100

26 25 24 23 22 21 20 10

FIG. 1

100

26 25 24 23 22 27 21 20 10

FIG. 2

100

26 25 28 24 23 22 21 20 10

FIG. 3

100

FIG. 4

27

FIG. 5

28

FIG. 6

FIG. 7

FIG. 8

FIG. 9

FIG. 10

EP 4 692 012 A1

FIG. 11

## INTERNATIONAL SEARCH REPORT

| International application No. |
|---|
| **PCT/CN2024/117081** |

| A. | CLASSIFICATION OF SUBJECT MATTER |
|---|---|

C03C17/34(2006.01)i; G02B1/113(2015.01)i

According to International Patent Classification (IPC) or to both national classification and IPC

| B. | FIELDS SEARCHED |
|---|---|

Minimum documentation searched (classification system followed by classification symbols)

IPC:C03C17; G02B1

Documentation searched other than minimum documentation to the extent that such documents are included in the fields searched

Electronic data base consulted during the international search (name of data base and, where practicable, search terms used)

CNABS, CNTXT, WPABS, DWPI, ENTXT, ENTXTC, Elsevier Science Direct, ISI Web of Science, 读秀, DUXIU, 超星科技数字图书馆, Chaoxing E-books, 中国期刊网全文数据库, CJFD: 华为技术有限公司, 玻璃, 膜, Si3N4, SiN+, CN+, AlN, TiN+, ZrN, SiC+, SiNxCy, SiO2, SiO, Al2O3, NbO+, Nb2O3, Nb2O5, TiO2, ZrO2, SiAlxOyNz, 高折射率, 低折射率, RI, 硬度, 色差, 透过, 附着, 划, 类金刚石, optic+, glass, coat+, refractive, hard+, diamond-like carbon, DLC, plurality, layer+, transmit+, silicon, aluminum, niobium, zirconium, titanium, oxide, nitride

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 210736572 U (SICHUAN CSG ENERGY CONSERVATION GLASS CO., LTD. et al.) 12 June 2020 (2020-06-12) description, paragraphs 6-19 | 1-22 |
| A | CN 114907020 A (SHENZHEN CSG APPLIED TECHNOLOGY CO., LTD. et al.) 16 August 2022 (2022-08-16) specific embodiments, and figures 1-4 | 1-22 |
| A | CN 113264691 A (TIANJIN SYP ENGINEERING GLASS CO., LTD.) 17 August 2021 (2021-08-17) specific embodiments, and figure 1 | 1-22 |
| A | CN 108732656 A (CORNING INC.) 02 November 2018 (2018-11-02) embodiments | 1-22 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 December 2024** | **17 December 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/117081** |

| C. | DOCUMENTS CONSIDERED TO BE RELEVANT | |
| --- | --- | --- |
| Category* | Citation of document, with indication, where appropriate, of the relevant passages | Relevant to claim No. |
| A | CN 111139431 A (GUANGDONG OPPO MOBILE TELECOMMUNICATIONS CORP., LTD.) 12 May 2020 (2020-05-12) entire document | 1-22 |
| A | US 2021122671 A1 (CORNING INC.) 29 April 2021 (2021-04-29) entire document | 1-22 |

Form PCT/ISA/210 (second sheet) (July 2022)

**INTERNATIONAL SEARCH REPORT**
**Information on patent family members**

International application No.

**PCT/CN2024/117081**

| Patent document cited in search report | | | Publication date (day/month/year) | Patent family member(s) | | | Publication date (day/month/year) |
|---|---|---|---|---|---|---|---|
| CN | 210736572 | U | 12 June 2020 | CN | 110467360 | A | 19 November 2019 |
| CN | 114907020 | A | 16 August 2022 | None | | | |
| CN | 113264691 | A | 17 August 2021 | None | | | |
| CN | 108732656 | A | 02 November 2018 | WO | 2014182639 | A1 | 13 November 2014 |
| | | | | KR | 20160005748 | A | 15 January 2016 |
| | | | | KR | 101642672 | B1 | 25 July 2016 |
| | | | | US | 2014335330 | A1 | 13 November 2014 |
| | | | | US | 9359261 | B2 | 07 June 2016 |
| | | | | EP | 3502754 | A1 | 26 June 2019 |
| | | | | JP | 2016528518 | A | 15 September 2016 |
| | | | | JP | 6171088 | B2 | 26 July 2017 |
| | | | | KR | 20160087930 | A | 22 July 2016 |
| | | | | KR | 101756610 | B1 | 10 July 2017 |
| | | | | EP | 2994784 | A1 | 16 March 2016 |
| | | | | EP | 2994784 | B1 | 13 March 2019 |
| | | | | US | 2014335332 | A1 | 13 November 2014 |
| | | | | US | 9079802 | B2 | 14 July 2015 |
| CN | 111139431 | A | 12 May 2020 | None | | | |
| US | 2021122671 | A1 | 29 April 2021 | WO | 2019027913 | A1 | 07 February 2019 |
| | | | | KR | 20200031679 | A | 24 March 2020 |
| | | | | KR | 102688559 | B1 | 26 July 2024 |

Form PCT/ISA/210 (patent family annex) (July 2022)

**EP 4 692 012 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311163164